# EUROPEAN PATENT SPECIFICATION

(11) **EP 0 660 884 B1**
(45) Date of publication and mention of the grant of the patent: **27.08.1997**
(21) Application number: 92922941.7
(22) Date of filing: 28.10.1992
(51) Int. Cl.: C23C 14/26

(54) **MELTING METHOD AT VACUUM EVAPORATION**
SCHMELZVERFAHREN BEI DER VAKUUMVERDAMPFUNG
PROCEDE DE FUSION LORS DE LA METALLISATION SOUS VIDE

(30) Priority: 29.10.1991 SE 9103162
(43) Date of publication of application: 05.07.1995
(73) Proprietor: APPLIED VACUUM TECHNOLOGIES 1 AB, S-580 05 Linköping (SE)
(72) Inventor: NORDLANDER, Johan, S-582 47 Linköping (SE)
(74) Representative: Berglund, Erik Wilhelm
(86) International application number: SE9200741
(87) International publication number: WO9309263

(56) References cited:
- DE-B- 1 207 179
- US-A- 4 528 939
- PATENT ABSTRACTS OF JAPAN, Vol. 9, No. 309, C318; & JP,A,60 149 767, publ 1985- 08-07 (NIPPON DENKI K.K.).

## Description

This invention concerns a method for melting, heating and evaporation of metal, for instance aluminum, in vacuo, particularly in shallow and/or toroidal crucibles, by induction to obtain a vaporization source.

It is known from WO-A-92/13980 to use a metal smelt, for instance an aluminum smelt, of relatively high temperature to metallize individual plastic CD-discs and articles like of low melting point, said metal smelt being briefly held very close to the article to be metallized. The method is concerned with the ability to coat articles quickly while minimizing the deposit of metal in wrong places.

One problem with the coating method taught by WO-A-92/13980, however, is that an aluminum smelt cannot be readily produced. Although the aforesaid patent application discloses that induction processes can be used, the induction heating of aluminum per se cannot be achieved as readily as, for instance, the induction heating of iron, since in the former case the inductive coupling to non-magnetic materials is smaller. When aluminum is heated normally under atmospheric conditions, the heating process will function relatively satisfactorily, although a tough layer of oxide will form on the surface of the aluminum bath. This oxide layer, however, can be scraped from the surface of the bath, therewith enabling the molten metal to be cast in a mould, for instance. However, when the smelt is to be used for vapour deposition purposes, it is important that no oxide layer is present on the surface of the smelt, since this would then prevent vaporization of the molten metal and the surface would no longer be bright, resulting in high thermal radiation. In other words, the presence of an oxide layer on the smelt would render the smelt impossible for use in the production of a metal coating by vapour deposition processes. Consequently, it is not possible to heat an aluminum smelt in an ambient oxygen containing atmosphere and then use the aluminum smelt for deposition or metal plating purposes.

When attempts are made initially to heat the smelt in vacuum conditions, the smelt will behave in a completely different way than it would otherwise do. For instance, because no oxide layer will be formed, the smelt is much more fluid and because the body to be smelted down is not heated and melted with exact homogeneity throughout its entirety and a precisely homogenous induction field cannot always be ensured instead the electric currents generated in the aluminium by induction and those forces acting on the aluminium will vary. This will result almost invariably in the aluminium splashing and spitting as it begins to melt and it is possible to lose the electric induction coupling to the aluminium completely in the case of certain crucible constructions which are desirable from other viewpoints. This spitting phenomenon is particularly manifest in the case of toroidal smelts that are desirable, for instance, in the manufacture of CD-discs. The fundamental cause of the difficulties is probably the result of inhomogeneities in the heated aluminium body in its solid state and also because non-uniformity in the induction field causes the aluminium to melt first at a distinct place/location on the aluminium body. When the aluminium in this distinct location becomes molten or fluid, the liquid aluminium will run immediately down to the bottom of the crucible, where, among other things, it fills out the requisite thermal expansion gap between crucible and aluminium body. When the aluminium runs thus to the bottom of the crucible, the induction currents in the aluminium body result in a higher current density at the location from which aluminium has run. This, in turn, may result in a lifting force of such magnitude (aluminium is a lightweight metal) as to subject the residual aluminium bridge to a dynamic lifting force at the same time as the aluminium body melts, resulting in aluminium being splashed or thrown away. This splashing can be repetitive and is, of course, quite unacceptable.

When induction-heating aluminum for instance, the heating ability is dependent on the frequency of the induction field. A lower frequency will result in more effective coupling and therewith in quicker heating. The power unit used in the induction heating process is normally less costly at lower frequencies. However, one drawback with the use of a lower frequency is that the dynamic lifting force is greater on that part of the metal which is first heated locally in the crucible. Lower frequencies thus result in greater problems with regard to the spitting of metal droplets from the crucible.

Gas-bubble inclusions may also be an explanation as to why aluminum spits from the crucible, or may at least be a contributory factor.

From US-A-4 528 939 it is known to heat and vaporize aluminum in an electrically conductive containment vessel so that the aluminum charge is heated by electrical induction. The vessel containing the metal therein may be heated and vaporized by inductive heating or ion bombardment with the coating or the crucible being of sufficient conductivity for completion of the current flow in the ion beam circuit.

In the copending WO-A-93/09264 a crucible is described that is very suitable for the provision of an aluminum vapour source were the inductive coupling may be directly to the aluminum.

Naturally, a smelt can be heated in other ways, but, since it is desired to place the smelt in a very precise manner, and to reduce the heating of the smelt in order to obtain a low total thermal load on both the crucible and the smelt itself and, for instance, on the CD-discs to be coated or plated, induction heating methods are still an attractive solution, although their use necessitates a solution to the problem occasioned by the instable heating of the smelt. An object of the present invention is therefore to provide a method and a smelt arrangement which will enable an aluminum smelt to be heated in vacuo in a controlled and "spitting-free" fashion.

The aforesaid problem is solved by preventing the aluminum body from melting excessively at any distinct location thereon. In other words, the metal forming the aluminum body must be prevented from melting at any one particular place on the body but melting shall take place at different points in time, so that there is always an electrical bridge beyond the location or locations where melting of the aluminum body happened to begin, as the aluminum body melts. These requirements can be achieved through the methods described in the claims.

Accordingly, it is possible in accordance with the present invention to prevent spitting or splashing of the aluminium by giving the aluminium body a height or vertical extension such as to render it impossible for the entire body to be melted down at once. The aluminium body may also include discs which are arranged in superimposed layers and mutually joined by short vertical posts or radially connected, mutually concentric rings. It is also conceivable to use aluminium bodies which comprise an alloyed bottom part and a non-alloyed upper part, therewith ensuring different melting temperatures, such that prior to melting of the upper layer, which constantly provides an electrical connection, sufficient of the bottom layer will have melted to ensure a circular contact. It is also conceivable to place other electrically conductive material in the crucible, for instance a copper or graphite annulus. This annulus may be placed around, beneath or in the toroidal case inwardly of the aluminium body.

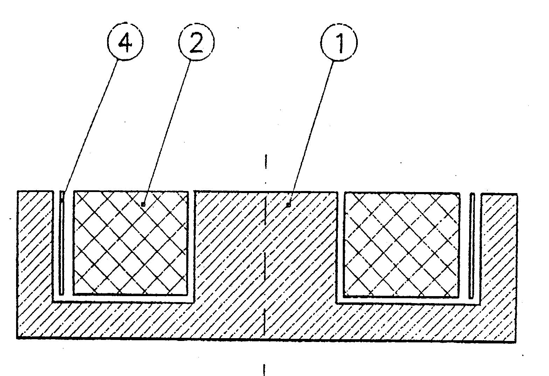

Further features of the invention and advantages afforded thereby will be evident from the following description made with reference to the accompanying drawing, which illustrates a crucible that contains aluminium.

Illustrated in the drawing is a toroidal crucible 1 in which an aluminium annulus 2 is placed with an intermediate clearance. The clearance is necessary in order to prevent the hot aluminium from cracking the crucible as the aluminium is heated from room temperature to its melting point. The aluminium annulus 2 is encircled by a graphite ring or band 4. In the illustrated case, an inductive field is generated with the aid of a coil placed beneath the crucible. The inductive field will be strongest at the bottom of the crucible and the aluminium located nearest the crucible bottom will melt first and if dividing or parting forces are generated in the annulus 2 as the heating progresses, the current circuit in the annulus 2 will remain closed through the graphite ring 4, so that power will still be delivered to the annulus 2 allowing the melting of the aluminium ring to continue without being disturbed by variations in current strength and field strength, such variations otherwise resulting in unstable conditions with excessively powerful dynamic lifting forces.

Because the induction coil is placed beneath the crucible, the distance to the smelt is short and the inductive energy transfer consequently good. Furthermore, the inductor is shielded against vaporized aluminium from the crucible itself and also against the danger of aluminium deposits and because subsequent short-circuiting between the turns of the inductor coil decrease. Furthermore, different crucible configurations, for instance configurations which are in accord with the shape of the articles to be coated or plated, can be used without inductor changes. The distance between inductor and crucible can also be adjusted with the aid of simple means, so as to obtain optimal coupling conditions.

As will be understood, it lies within the concept of the invention to replace the graphite ring with a ring made of some other material of good electrical conductivity, high melting point and low vapourizing rate up to intended operating temperatures.

It also lies within the concept of the invention to use other substances than aluminium which behave in a similar manner when heating to a vapourized state. In this case, it may be necessary to use other materials which take care of the electrical short-circuiting or shunting to prevent and counter movements in the smelt.

## Claims

1. A method for melting, heating and evaporation of metal, for instance aluminum, in vacuo, particularly in shallow and/or toroidal crucibles, by induction,
**characterized** in that the metal body is prevented from melting excessively at any distinct location at the same time by arranging a ring or disc of electrically conductive material around, below or in the case of a toroidal crucible inside of the body that is to be melted.

2. A method according to Claim 1, **characterized** in that the ring or disc is constituted by graphite or copper.

3. A method according to claim 1 or 2, **characterized** in that the metal body includes discs which are arranged in superimposed layers and mutually joined by short vertical posts or radially connected, mutually concentric rings.

4. A method for melting, heating and evaporation of metal, for instance aluminum, in vacuo, particularly in shallow and/or toroidal crucibles, by induction,
**characterized** in that the metal body is prevented from melting at any distinct location at the same time by the metal body comprising an alloyed bottom part and a non alloyed upper part, therewith ensuring different melting temperatures.

## Patentansprüche

1. Verfahren zum Schmelzen, Erhitzen und verdampfen von Metall, beispielsweise Aluminium, unter Vakuum, insbesondere in flachen und/oder ringförmigen Schmelztiegeln, und mittels Induktion, dadurch gekennzeichnet, dass ein übermässiges Schmelzen des Metallkörpers zur gleichen zeit an irgendeiner bestimmten Stelle verhindert wird, indem ein Ring oder eine Scheibe aus elektrisch leitendem Material um, unter, oder im Fall eines ringförmigen Schmelztiegels, innerhalb des zu schmelzenden Körpers angeordnet wird.

2. Verfahren nach Anspruch 1, dadurch gekennzeichnet, dass der Ring oder die Scheibe aus Graphit oder aus Kupfer besteht.

3. Verfahren nach Anspruch 1 oder 2, dadurch gekennzeichnet, dass der Metallkörper Scheiben aufweist, welche in üibereinanderliegenden Schichten angeordnet sind und durch kurze, senkrechte Stützen oder durch radial miteinander verbundene konzentrische Ringe miteinander verbunden sind.

4. Verfahren zum Schmelzen, Erhitzen und Verdampfen von Metall, beispielsweise Aluminium, unter Vakuum, insbesondere in flachen und/oder ringförmigen Schmelztiegeln, und mittels Induktion, dadurch gekennzeichnet, dass ein übermässiges Schmelzen des Metallkörpers zur gleichen Zeit an irgendeiner bestimmten Stelle verhindert wird, indem der Metallkörper einen legierten unteren Teil und einen unlegierten oberen Teil aufweist, wodurch unterschiedliche Schmelztemperaturen gewährleistet sind.

## Revendications

1. Procédé de fusion, de chauffage et d'évaporation de métaux tels que l'aluminium sous vide et par induction, particulièrement dans des creusets peu profonds et/ou toroïdaux, caractérisé en ce qu'une fusion excessive simultanée du corps métallique à un endroit distinct quelconque est évitée en plaçant au même temps un anneau ou un disque d'une matière électriquement conductrice autour, en-dessous ou, au cas d'un creuset toroïdal, à l'intérieur du corps à fondre.

2. Procédé selon la revendication 1, caractérisé en ce que ledit anneau ou disque est constitué de graphite ou de cuivre.

3. Procédé selon la revendication 1 ou 2, caractérisé en ce que ledit corps métallique comporte des disques disposés en couches superposées et reliés entre eux par des montants verticaux courts ou par des anneaux concentriques radialement connectés.

4. Procédé de fusion, de chauffage et d'évaporation de métaux tels que l'aluminium sous vide et par induction, particulièrement dans des creusets peu profonds et/ou toroïdaux, caractérisé en ce qu'une fusion excessive simultanée du corps métallique à un endroit distinct quelconque est évitée par le fait que le corps métallique comporte une partie inférieure alliée et une partie supérieure non alliée, assurant ainsi des températures de fusion différentes.
